# EUROPEAN PATENT SPECIFICATION

(11) **EP 1 325 662 B1**
(45) Date of publication and mention of the grant of the patent: **12.04.2006**
(21) Application number: 01967890.3
(22) Date of filing: 17.09.2001
(51) Int. Cl.: H04R 1/02, H05K 5/02

(54) **Hand-held electronic mobile equipment**
Mobiles elektronisches Handgerät
Equipement mobile électronique qui tient dans la main

(30) Priority: 18.09.2000 SE 0003323; 14.12.2000 SE 0004621; 18.12.2000 US 256809 P
(43) Date of publication of application: 09.07.2003
(73) Proprietor: TELEFONAKTIEBOLAGET LM ERICSSON (publ), 164 83 Stockholm (SE)
(72) Inventor: HOLMBERG, Per, S-240 10 Dalby (SE); ERIKSSON, Lars, S-361 31 Emmaboda (SE)
(74) Representative: Petri, Stellan
(86) International application number: PCT/SE2001/001976
(87) International publication number: WO 2002/023965

(56) References cited:
- EP-A- 0 008 772
- WO-A-95/09515
- DE-C- 19 732 184
- GB-A- 2 021 352
- GB-A- 2 173 887
- GB-A- 2 249 454
- SE-B- 358 792
- US-A- 4 244 096
- US-A- 4 264 659
- US-A- 5 979 591
- PATENT ABSTRACTS OF JAPAN vol. 007, no. 017 (E-154), 22 January 1983 (1983-01-22) & JP 57 173295 A (TOKYO SHIBAURA DENKI KK), 25 October 1982 (1982-10-25)
- PATENT ABSTRACTS OF JAPAN vol. 012, no. 261 (E-636), 22 July 1988 (1988-07-22) & JP 63 046100 A (MATSUSHITA ELECTRIC IND CO LTD), 26 February 1988 (1988-02-26)

## Description

### Technical Field

The present invention concerns a hand-held mobile electronic equipment comprising a gas permeable cloth covering an opening in the housing of the electronic equipment. The cloth covering the opening is given a support.

### State of the Art

Cloths of the above kind are at present used in many different contexts. In this application the main use of the cloth is to keep out harmful substances and hinder the harmful substances from harming electronic or mechanical devices placed in connection to an opening of a housing of an electronic equipment. The harmful substances may be different fluids, such as water, moist, dust, dirt, particles etc. Thus, the cloth should be impermeable to fluids, moist, dust, dirt, particles etc. At the same time the cloth should be permeable to gases, especially air. The devices to be protected by the cloth may be microphones and loudspeakers and, thus, the cloth should not hinder sound from going through. Furthermore, the cloth may be used to protect battery air inlets or inlets for other electronic units such as transmitters and receivers. One aim is to be able to use electronic equipment in harsh environments, such as at sea, outdoors, at building sites, in heavy industry etc.

The term electronic equipment includes portable radio communication equipment. The term portable radio communication equipment includes all equipment such as mobile telephones, pagers, communicators, i.e. electronic organizers, smartphones or the like.

It is not possible to use the cloths of the prior art to cover large openings. The large openings may be for large loudspeakers, ventilation means, computers and/or other electronic devices. When the cloth is stretched over a large opening the stress on the cloth will be substantial. The cloth normally used is much too yielding, which means that it will not stand even small pressures or any kind of mechanical influence without being damaged. If the cloth is damaged it will not be able to fulfil its purpose. Furthermore, large cloths will be harder to fasten at the housing or frame. A larger cloth is heavier and the pressure or mechanical influence on the periphery, where the cloth is attached to the frame, will threaten to damage the periphery of the cloth, tearing it apart and making it lose its grip with the opening. The only possible solution according to the prior art is to have very thick and thus heavy cloths. In addition to the problems mentioned above such cloths are expensive. The cloths of the prior art used to cover small openings are also difficult to fasten at the edge of the opening.

### Summary of the Invention

One object of the present invention is to have a good support for cloths covering an opening of an electronic equipment.

A further object is to simplify the mounting of the cloth in the opening of the housing or frame of the electronic equipment.

According to the invention as defined in claim 1 a stabilising structure is formed, allowing the cloth to cover large openings without being harmed or being too yielding. The stabilising structure may have many different designs such as a net, longitudinal or transversal bars, which may be crossed and/or overlapping, forming plates, rings, triangles, rectangles or any other form. The formations may be flat or may form a framework having one or more points of support bearing against the frame. The stabilising structure may be formed by thickened parts of the cloth.

Furthermore, the cloth may be given a support by stretching the cloth and by fixing it in a stretched condition at the edges of the opening and/or at the points of support. If the cloth is made of an elastic material the stretched area will remain for a longer period of time compared to if the cloth is of a non-elastic material. Furthermore it will be easier to stretch an elastic cloth when mounting it over the opening. The support to the cloth may be given by a combination of one or more of the above stated supports or stabilising structures.

The stabilising structure may be placed on either side of the cloth or may be integrated in the cloth. The stabilising structure may be made of plastics, metal, wood or any other suitable material. Furthermore the cloth is furnished with means of attachment at least in one location on the surface or at the edge of the cloth. Thus, according to the invention large cloths may be mounted over large openings, whereby the cloth is used to stop fluids such as water, moist, dirt, dust and other particles but to let air and thus sound through. Furthermore, the cloth will withstand pressures and mechanical influences. All in harsh environments.

According to an embodiment of the invention the cloth may be rather thin and have the same thickness throughout the part covering the opening. The cloth according to the invention is easy to mount as the stabilising structure may be furnished with means of attachment, fixing the cloth in a proper way over the opening. The means of attachment may comprise snaps, barbs, screw joints, threads, seams, clamps etc.

The openings may have many different forms, such as circular, oval, rectangular, polygonal etc.

It should be emphasised that the term "comprises/comprising" when used in this description is taken to specify the presence of stated features, integers, steps or components but does not preclude the presence or addition of one or more other features, integers, steps, components or groups thereof.

### Brief Description of the Drawings

The invention will be described more closely below, with reference to the enclosed drawings. In the enclosed drawings,
Fig. 1 is a schematic perspective view of a stabilising structure placed under a cloth,
Fig. 2 is a section of a part of the cloth and a part of a point of support,
Fig. 3 is a section through a part of the cloth having a means of attachment fixed to a housing of an electronic equipment,
Fig. 4 is a section through a part of a cloth having an alternative means of attachment fixed to a housing of an electronic equipment, and
Fig. 5 is a section through a part of a cloth having an integrated stabilising structure.

### Detailed Description of the Invention

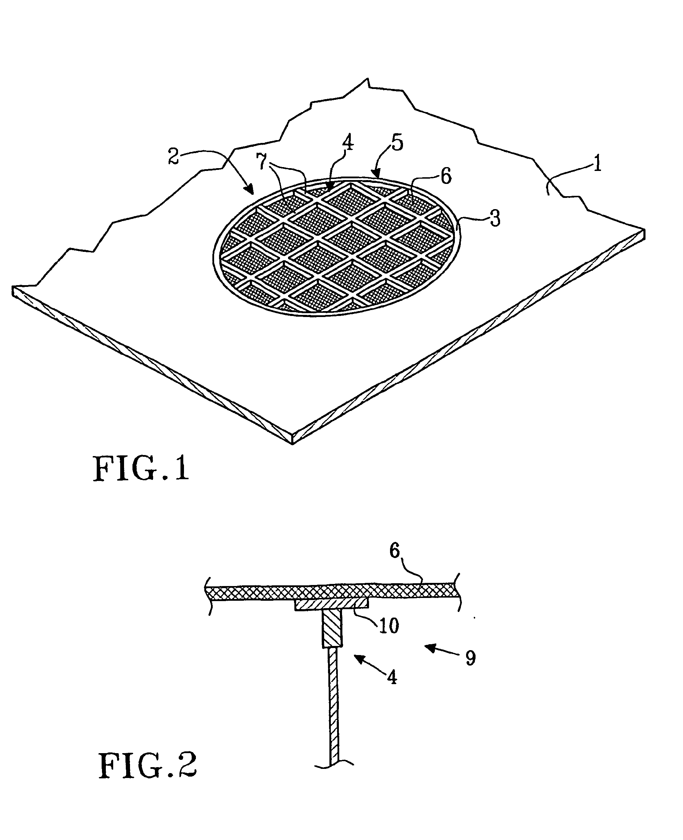

In Fig. 1 one embodiment of the present invention is shown. A housing or frame 1 of an electronic equipment such as a mobile telephone is shown. The housing 1 has an opening 2 for communication with either a microphone or a loudspeaker (not shown). The opening 2 is covered by a cloth 6, which is supported by a stabilising structure 4. The stabilising structure 4 has at least one means of attachment 3. The means of attachment 3 fix the stabilising structure 4 to the housing 1 at the edge 5 of the opening 2. A person skilled in the art realises that any number of means of attachment may be used. In the shown embodiment the stabilising structure 4 has crossed bars 7 forming a net.

The stabilising structure 4 may be placed on either side of the cloth 6. When the stabilising structure 4 is placed on top of the cloth 6, the cloth 6 is normally fixed to the stabilising structure 4 by means of glue, welding etc. A stabilising structure 4 on top of the cloth 6 will function as an impact protection.

A structure forming a point of support 9 is shown in Fig. 2. On top of the point of support 9 a plate 10 receives the cloth 6. The plate 10 of the point of support 9 may also receive a bar 7 of the stabilising structure 4. Thus, the point of support 9 will take up a part of the load of the cloth 6 and/or stabilising structure 4. Normally a number of points of support 9 are arranged. The plate 10 will help to distribute the load on a large part of the cloth 6, reducing the risk of mechanical influence on the cloth 6. The point of support 9 is integrated with or supported in the housing 1.

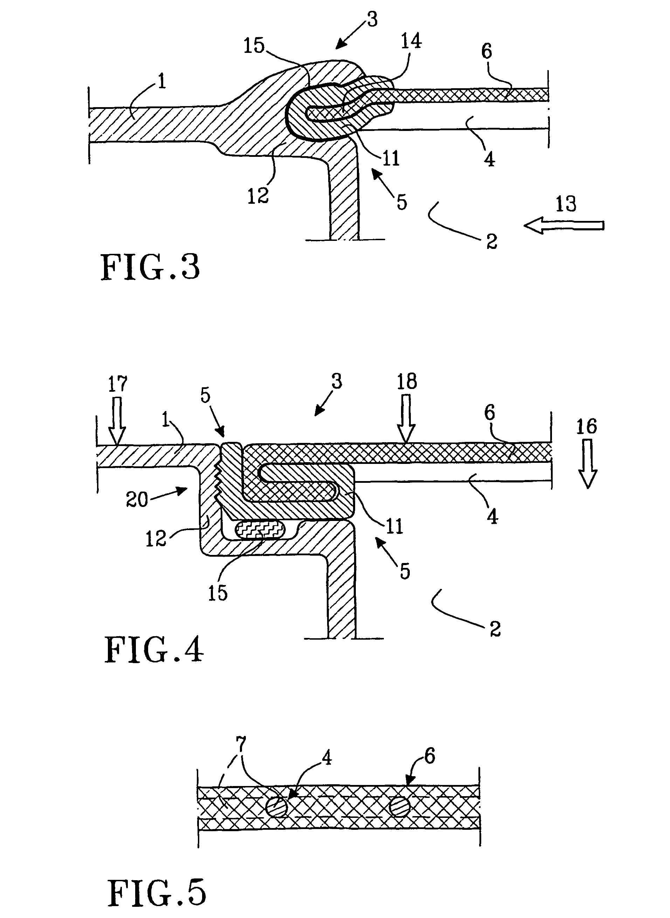

The cloth 6 is held at the edge 5 of the opening 2 by a means of attachment 3. In the embodiment of Fig. 3 the means of attachment 3 comprise a male part 11 and a female part 12. The male part 11 is fixed to the cloth 6, by clamping the edge 14 of the cloth 6. The male part 11 clamping the cloth 6 is received in the female part 12. The male part 11 is assembled in a mainly horizontal direction in the female part 12. The male part 11 may be elastic to snap into the female part 12. A gasket 15 is arranged between the male and female parts 11,12. The function of the gasket 15 is to hinder fluids and moisture to come into the electronic equipment at the means of attachment 3.

Depending on the size of the opening 2, the only stabilising structure may be the way the cloth 6 is attached to the edge 5 of the opening 2. The cloth 6 is normally stretched at the assembly. However, for larger openings further stabilising structures 4, including one or more points of support, are arranged.

In the embodiment of Fig. 4 the edge 14 of the cloth 6 is folded into a slit of the male part 11. The cloth 6 may be held at the male part 11 by means of glue, welding, friction and/or that the male part 11 is pretensioned to give a clamping force on the cloth 6. In this embodiment the female part 12 is actually a part of the housing 1 and has two perpendicular surfaces, one of which has a recess for receiving a gasket 15. The gasket 15 seals between the male and female parts 11,12.

The male part 11 is held at the female part 12 in that barbs, cuts, grooves or the like 20 of respective part lock into each other. In other embodiments the male and female parts 11,12 are attached to each other by means of an adhesive, by welding or the like. The male part 11 has an outer contour corresponding to the inner contour of the female part 12. In a further embodiment the outer dimension of the male part 11 is slightly larger than the inner dimension of the female part 12 to give a force fit.

In the embodiment of Fig. 5 the stabilising structure 4 is received inside the cloth 6. This is done by means of bars 7 interwoven into the cloth 6, or by having channels in the cloth, which channels will receive bars 7. The edge 14 of the cloth 6 is attached to the edge 5 of the opening 2 in any of the above ways. A person skilled in the art realises that even if a cloth 6 having enclosed bars 7 is used the other stabilising structures 4 may be used, including one or more points of support 9.

## Claims

1. Hand-held mobile electronic equipment comprising a construction covering an opening (2) in a housing (1) of said electronic equipment, by means of a cloth (6), which is permeable to air but impermeable to fluids, moist, dirt, and dust, **characterized in that** said cloth is sealingly arranged to cover said opening, and is supported by a stabilising structure (4), in close contact with or attached to the cloth and extending over said opening.

2. The equipment of claim 1, **characterized in that** the stabilising structure (4) comprises one or more bars (7) and that the stabilising structure (4) is placed on either side of the cloth (6) or is integrated in the cloth (6).

3. The equipment of claim 2, **characterized in that** the construction is fixed to the edge (5) of the opening (2) by means of a means of attachment (3) comprising a male part (11) and a female part (12).

4. The equipment of any of the previous claims, **characterized in that** the cloth (6) and/or the stabilising structure (4) is supported in one or more points of support (9).

5. The equipment of claim 4, **characterized in that** the point of support (9) comprises a plate (10) for contact with the cloth (6) or the stabilising structure (4) and that the point of support (9) is supported in the housing (1) of the electronic equipment.

6. The equipment of any of the claims 3 to 5, **characterized in that** a gasket (15) is arranged between the male part (11) and the female part (12) and that the edge (14) of the cloth (6) is received in the male part (11).

7. The equipment of claim 6, **characterized in that** the male part (11) is clamped on the edge (14) of the cloth (6) .

8. The equipment of claim 6, **characterized in that** the edge (14) of the cloth (6) is received in a slit of the male part (11).

9. The equipment of any of the claims 3 to 8, **characterized in that** the female part (12) enclose the male part (11) at assembly.

10. The equipment of any of the claims 3 to 8, **characterized in that** the male part (11) and female part (12) are connected by means of welding, an adhesive, barbs, cuts, or grooves.

11. The equipment of any of the previous claims, **characterized in that** the stabilising structure (4) is interwoven into the cloth (6).

12. The equipment of any of the claims 1 to 10, **characterized in that** bars (7) received in channels of the cloth (6) form said stabilising structure (4).

13. The equipment of any of the claims 1 to 10, **characterized in that** the stabilising structure is formed by thickened parts of the cloth (6).

14. The equipment of any of the previous claims, **characterized in that** the electronic equipment is a mobile telephone.

15. The equipment of any of the previous claims, **characterized in that** the cloth (6) is made of an elastic material.

16. The equipment of any of the previous claims, **characterized in that** said opening is intended for sound transmission to a microphone or from a loudspeaker.

17. The equipment of any of the previous claims, **characterized in that** the stabilising structure (4) is a net, longitudinal and/or transversal bars, which may be crossed and/or overlapping, forming plates, rings, triangles, or rectangles.

## Patentansprüche

1. Mobiles elektronisches Handgerät, umfassend eine Konstruktion, die eine Öffnung (2) in einem Gehäuse (1) des elektronischen Gerätes mittels eines Gewebes (6) abdeckt, das für Luft durchlässig, aber für Flüssigkeiten, Feuchtigkeit, Schmutz und Staub undurchlässig ist, **gekennzeichnet dadurch, dass** das Gewebe abdichtend angeordnet ist, um die Öffnung abzudecken, und durch einen stabilisierenden Aufbau (4) in engem Kontakt mit oder angebracht an dem Tuch ist und sich über die Öffnung erstreckt.

2. Das Gerät nach Anspruch 1, **gekennzeichnet dadurch, dass** der stabilisierende Aufbau (4) eine oder mehr Leisten (7) umfasst, und **dadurch**, dass der stabilisierende Aufbau (4) auf einer von beiden Seiten des Gewebes (6) platziert oder in das Gewebe (6) integriert ist.

3. Das Gerät nach Anspruch 2, **gekennzeichnet dadurch, dass** die Konstruktion an der Kante (5) der Öffnung (2) mittels einer Befestigung (3) fixiert ist, die einen eindringenden Teil (11) und einen aufnehmenden Teil (12) umfasst.

4. Das Gerät nach beliebigen der vorherigen Ansprüche, **gekennzeichnet dadurch, dass** das Gewebe (6) und/oder der stabilisierende Aufbau (4) in einem oder mehr Punkten einer Stütze (9) gestützt wird.

5. Das Gerät nach Anspruch 4, **gekennzeichnet dadurch, dass** der Punkt einer Stütze (9) eine Platte (10) für einen Kontakt mit dem Gewebe (6) oder dem stabilisierenden Aufbau (4) umfasst, und dass der Punkt einer Stütze (9) in dem Gehäuse (1) des elektronischen Gerätes gestützt wird.

6. Das Gerät nach beliebigen der Ansprüche 3 bis 5, **gekennzeichnet dadurch, dass** eine Dichtung (15) zwischen dem eindringenden Teil (11) und dem aufnehmenden Teil (12) angeordnet ist, und dass die Kante (14) des Gewebes (6) in dem eindringenden Teil (11) aufgenommen wird.

7. Das Gerät nach Anspruch 6, **gekennzeichnet dadurch, dass** der eindringende Teil (11) an der Kante (14) des Gewebes (6) geklemmt wird.

8. Das Gerät nach Anspruch 6, **gekennzeichnet dadurch, dass** die Kante (14) des Gewebes (6) in einem Schlitz des eindringenden Teils (11) aufgenommen wird.

9. Das Gerät nach beliebigen der Ansprüche 3 bis 8, **gekennzeichnet dadurch dass** der aufnehmende Teil (12) den eindringenden Teil (11) im Aufbau einschließt.

10. Das Gerät nach beliebigen der Ansprüche 3 bis 8, **gekennzeichnet dadurch, dass** der eindringende Teil (11) und der aufnehmende Teil (12) mittels Schweißen, eines Klebstoffs, Spitzen, Schnitten oder Nuten verbunden sind.

11. Das Gerät nach beliebigen der vorherigen Ansprüche, **gekennzeichnet dadurch, dass** der stabilisierende Aufbau (4) in das Gewebe (6) verflochten ist.

12. Das Gerät nach beliebigen der Ansprüche 1 bis 10, **gekennzeichnet dadurch, dass** Leisten (7), die in Kanälen des Gewebes (6) aufgenommen sind, den stabilisierenden Aufbau (4) bilden.

13. Das Gerät nach beliebigen der Ansprüche 1 bis 10, **gekennzeichnet dadurch, dass** der stabilisierende Aufbau durch verdickte Teile des Gewebes (6) gebildet wird.

14. Das Gerät nach beliebigen der vorherigen Ansprüche, **gekennzeichnet dadurch, dass** das elektronische Gerät ein Mobiltelefon ist.

15. Das Gerät nach beliebigen der vorherigen Ansprüche, **gekennzeichnet dadurch, dass** das Gewebe (6) aus einem elastischen Material hergestellt ist.

16. Das Gerät nach beliebigen der vorherigen Ansprüche, **gekennzeichnet dadurch, dass** die Öffnung für Klangübertragung zu einem Mikrofon oder von einem Lautsprecher gedacht ist.

17. Das Gerät nach beliebigen der vorherigen Ansprüche, **gekennzeichnet dadurch, dass** der stabilisierende Aufbau (4) ein Netz, Längs- und/oder Querleisten ist, was gekreuzt und/oder überlappt werden kann, wobei Platten, Ringe, Dreiecke oder Rechtecke gebildet werden.

## Revendications

1. Equipement électronique mobile portatif comprenant une structure couvrant une ouverture (2) réalisée dans un boîtier (1) dudit équipement électronique, au moyen d'un tissu (6), qui est perméable à l'air mais imperméable à des fluides, à de l'humidité, à de la saleté et à de la poussière, **caractérisé en ce que** ledit tissu est agencé pour couvrir de manière étanche ladite ouverture, et est supporté par une structure (4) de stabilisation, en contact étroit avec le, ou assujetti au, tissu et s'étendant par dessus ladite ouverture.

2. Equipement selon la revendication 1, **caractérisé en ce que** la structure (4) de stabilisation comprend une ou plusieurs barres (7) et **en ce que** la structure (4) de stabilisation est placée de chaque côté du tissu (6) ou est intégrée au tissu (6).

3. Equipement selon la revendication 2, **caractérisé en ce que** la structure est fixée au bord (5) de l'ouverture (2) en utilisant un moyen d'assujettissement (3) comprenant une partie mâle (11) et une partie femelle (12).

4. Equipement selon l'une quelconque des revendications précédentes, **caractérisé en ce que** le tissu (6) et/ou la structure (4) de stabilisation sont supportés en un ou plusieurs points du support (9).

5. Equipement selon la revendication 4, **caractérisé en ce que** le point de support (9) comprend une plaque (10) de contact avec le tissu (6) ou bien avec la structure (4) de stabilisation, et **en ce que** le point de support (9) est supporté dans le boîtier (1) de l'équipement électronique.

6. Equipement selon l'une quelconque des revendications 3 à 5, **caractérisé en ce qu'**une garniture (15) est agencée entre la partie mâle (11) et la partie femelle (12) et **en ce que** le bord (14) du tissu (6) est reçu dans la partie mâle (11).

7. Equipement selon la revendication 6, **caractérisé en ce que** la partie mâle (11) est serrée sur le bord (14) du tissu (6).

8. Equipement selon la revendication 6, **caractérisé en ce que** le bord (14) du tissu (6) est reçu dans une fente de la partie mâle (11).

9. Equipement selon l'une quelconque des revendications 3 à 8, **caractérisé en ce que** la partie femelle (12) entoure la partie mâle (11) lors de l'assemblage.

10. Equipement selon l'une quelconque des revendications 3 à 8, **caractérisé en ce que** la partie mâle (11) et la partie femelle (12) sont reliées au moyen d'une soudure, d'un adhésif, de barbes, de découpes ou de cannelures.

11. Equipement selon l'une quelconque des revendications précédentes, **caractérisé en ce que** la structure (4) de stabilisation est imbriquée dans le tissu (6).

12. Equipement selon l'une quelconque des revendications 1 à 10, **caractérisé en ce que** les barres (7) reçues dans des rainures du tissu (6) forment ladite structure (4) de stabilisation.

13. Equipement selon l'une quelconque des revendications 1 à 10, **caractérisé en ce que** la structure de stabilisation est formée par des parties épaissies du tissu (6).

14. Equipement selon l'une quelconque des revendications précédentes, **caractérisé en ce que** l'équipement électronique est un téléphone mobile.

15. Equipement selon l'une quelconque des revendications précédentes, **caractérisé en ce que** le tissu (6) est réalisé à partir d'un matériau élastique.

16. Equipement selon l'une quelconque des revendications précédentes, **caractérisé en ce que** ladite ouverture est prévue pour transmission du son à un microphone, ou à partir d'un haut-parleur.

17. Equipement selon l'une quelconque des revendications précédentes, **caractérisé en ce que** la structure (4) de stabilisation est un filet, des barres longitudinales et/ou transversales, qui peuvent être croisées et/ou se chevaucher, formant des plaques, des anneaux, des triangles ou des rectangles.
